# EUROPEAN PATENT APPLICATION

(11) **EP 3 125 043 A1**
(43) Date of publication of application: **01.02.2017**
(21) Application number: 15002301.8
(22) Date of filing: 31.07.2015
(51) Int. Cl.: G03F 7/20, G03F 7/24

(54) **FLEXOGRAPHIC PRINTING PLATES AND METHODS**

(71) Applicant: Chemence, Inc., Alpharetta, GA 30005 (US)
(72) Inventor: MANEIRA, John P., Milton, Georgia 30004 (US)
(74) Representative: Morgan, David James

(57) **Abstract**

Flexography relief images are produced in currently-available sheet photopolymers by printing them with one inkjet printer pass using solvent-based inks without the need for an inkjet-receptive coating. A solvent ink that will adhere to the surface of the photopolymer slip film with no coating is used and, in embodiments, quick-dried to maximize image quality by heating the inked surface up to about 50°C. In embodiments, sheet photopolymer plates so masked and exposed can then be exposed to UV light in a modified printer that, in effect, transforms a batch process to a continuous one.

## Description

### Cross-References to Related Applications

This application is a Continuation-In-Part of U.S. Patent Application No. 13/902,301 filed May 24, 2013, which is the non-provisional of U.S. Provisional Patent Application No. 61/816,366 filed April 26, 2013. It is also a Continuation-In-Part of U.S. Patent Application No. 14/176,110 filed February 9, 2014. These applications are owned in common and have one inventor in common, and are incorporated into the present application in their entireties for all purposes.

### Background of Invention

Field of the Invention:

This invention is in the field of printing, more specifically in the field of flexography and still more particularly the field of making flexographic printing plates from sheet photopolymer base plates.

Description of the Related Art:

Flexographic printing is a printing process which uses a flexible rubber or photopolymer relief plate, prepared with raised areas called relief areas, corresponding to an image to be printed, and surrounded by lower areas called floor areas. The plate is typically secured to a revolving drum which is contacted by an anilox roll system to coat the relief areas with ink and subsequently press the inked areas against a moving sheet of, e.g., paper or corrugated box board. The flexible printing plates may alternatively be applied to plate mounts, e.g., hand stamps, or, potentially, non-planar surfaces other than drums. Images for flexographic printing are typically created by using a negative of an image to mask non-image areas on a layer of photosensitive polymer ("photopolymer"). Photopolymers cure by crosslinking under exposure to ultraviolet (hereinafter "UV") radiation. The plates may be imaged digitally (what is known as computer-to-plate or CTP) or by the analog process of exposing and developing traditional film. Such films (as supplied by Kodak, Fuji, etc.) are processed into negatives via an image setter.

Another method of making negatives uses an inkjet printer to print a UV-blocking ink onto a clear plastic, e.g., polyester, material. The surface of the plastic material must be inkjet-receptive or made to be inkjet-receptive, that is, able to create an acceptably stable and detailed image, i.e., one that adheres to the plastic and dries quickly without migrating. The plastic material may be made inkjet-receptive by coating it with an inkjet-receptive coating, e.g., a micro-porous coating or a coating of inkjet-receptive polymer, or the material may be treated in some other manner such as acid etching, etc. to produce a surface that allows the ink to adhere to the film and dry quickly without migrating. The uncoated plastic material may alternatively be printed with an inkjet ink directly so long as the ink and the plastic are mutually compatible. The printed image must also have an opacity of at least about 3.0 to prevent UV curing of unexposed photopolymers during the amounts of time required to cure the exposed photopolymers.

Parent Patent Application No. 14/027,760, incorporated by reference into this application in its entirety, describes technology for use with liquid photopolymers that is similar to that described and claimed in the present application.

A prior-art method of making a flexo plate from a sheet photopolymer, described in U.S. Patent Application Publication No. 20060073417, comprises the steps of providing a sheet photopolymer substrate having a top surface and an opposed bottom surface; image-wise ink jetting an inkjet composition onto a portion of the top surface of the photopolymer substrate to provide a photomask layer, wherein the photomask layer has an optical density of at least about 2; exposing the photopolymer substrate to UV radiation to cure an unmasked portion of the photopolymer substrate; and processing the photopolymer substrate under conditions effective to render the cured unmasked portion of the photopolymer layer into a raised image surface suitable for use in a flexographic printing process. The top surface of the sheet photopolymer must be pretreated with a non-gelatinous inkjet receptive coating before it is inkjet printed.

An important point to be made about the related art described above is that prior to the above-cited parent applications, any inkjet inks intended to be sufficiently opaque in single non-overlapping passes of the printer head have necessarily been water-based. As a result, the above-described print surfaces had to employ a microporous or other inkjet-receptive coating to produce a surface that allows water-based ink to adhere to the film and dry quickly without migrating. It has been possible to create sufficient opacity using solvent-based inks, but only by applying multiple layers of ink with overlapping passes of an inkjet printer head. This requires significantly more time for application and drying of the ink. U.S. Application No. 13/902,301 by the instant inventor, incorporated by reference into this application in its entirety, describes and claims solvent-based inkjet inks and combinations of these with films they are printed on in single non-overlapping print head passes, to produce negatives which are sufficiently opaque to UV radiation to make flexo printing plates.

### Brief Description of the Invention

### Objects of the Invention:

The principal object of this invention is to enable making flexographic plates from sheet photopolymers by printing them without the need for pre-applying an inkjet-receptive coating.

Another object of the invention is to improve the quality and increase the production speed of such plates using solvent-based inkjet inks which are of sufficient opacity that only one inkjet layer is needed, and exposure to UV can be performed without using a conventional exposure unit.

### Summary of the Invention:

The present invention enables relief images to be produced in currently-available sheet photopolymers by printing them with single non-overlapping print head passes using solvent-based inks without the need for an inkjet-receptive coating. A solvent ink that will adhere to the surface of the photopolymer slip film with no coating is used and, in embodiments, quick-dried to maximize image quality by heating the inked surface up to about 50°C. In embodiments, sheet photopolymer plates so produced can then be exposed to UV light in a modified printer that, in effect, transforms a batch process to a continuous one. These and other benefits will become clear in the following detailed description and attached drawings.

According to one aspect of the present invention a method for making a flexographic printing plate comprises :
(a) adding a sufficient amount of UV absorbers to a solvent-based ink to create an ink composition having an opacity in the UV spectrum of at least about 3;
(b) providing a sheet photopolymer having a backing sheet, the backing sheet having a bottom surface, a photopolymer layer on top of the backing sheet, the photopolymer layer having a top surface;
(c) applying a single layer of the ink composition onto a portion of the top surface to provide a photomask image;
(d) optionally exposing the bottom surface to UV radiation sufficient to cure a floor thickness of the photopolymer layer of at least zero thickness adjacent to the backing sheet;
(e) exposing the top surface to UV radiation sufficient to cure the unmasked photopolymer layer to a depth of cured photopolymer that is contiguous with the floor thickness; and
(f) processing the exposed photopolymer substrate under conditions effective to render the cured unmasked portion of the photopolymer layer into a raised image surface suitable for use in a flexographic printing process.

Preferably said top surface comprises a slip film and the photomask layer is applied to the slip film.

Suitably after step (c), the surface to which said ink composition is applied is heated.

Conveniently after step (c), the surface to which said ink composition is applied is heated.

According to another aspect of the invention a laminate comprises
a sheet photopolymer having a top surface;
a solvent-based ink composition applied to a portion of the top surface to produce a photomask image in which every portion of the image is created in single non-overlapping passes of an inkjet print head;
the solvent-based ink composition comprising at least one UV radiation-absorbing substance and at least one other UV radiation-filtering substance taken from the list of:
a. at least one fluorescent substance;
b. at least one UV radiation-reflecting substance; and
c. any combination of the above;
the composition when dry on the top surface having a UV opacity of at least about 3.

According to a further aspect of the invention a machine is provided for making a flexo plate, the machine comprising an inkjet printer, the printer comprising programmable means for inputting, printing, and outputting a sheet photopolymer with a printed surface; an ink treating section contiguous with the printer output comprising programmable means for taking in the printed sheet photopolymer line-by-line as it is printed, treating it, and outputting the treated sheet photopolymer; and
an exposure section contiguous with the treating section output comprising programmable means for taking in the printed and treated sheet photopolymer and exposing it to actinic radiation

Preferably said ink treating section heats the printed surface and said exposure section comprises ultraviolet-emitting LEDs.

Suitably there is a plate finishing section contiguous with said exposure section.

### Brief Description of the Drawings

Figure 1 is a perspective view of a flexographic plate in use on a printing machine.
Figure 2 is a cross-sectional view of sheet photopolymer as used in both the prior art and the present invention.
Figure 3 is a cross-sectional view of a prior art method of using a sheet photopolymer in an arrangement of other layers in an exposure unit to make a flexographic plate.
Figure 4 is a cross-sectional view of a solvent ink relief image negative printed on the slip film of a sheet photopolymer in accordance with the first embodiment of the present invention.
Figure 5 is a cross-sectional schematic of a combined inkjet printing and relief image creating machine.

### Detailed Description of the Invention

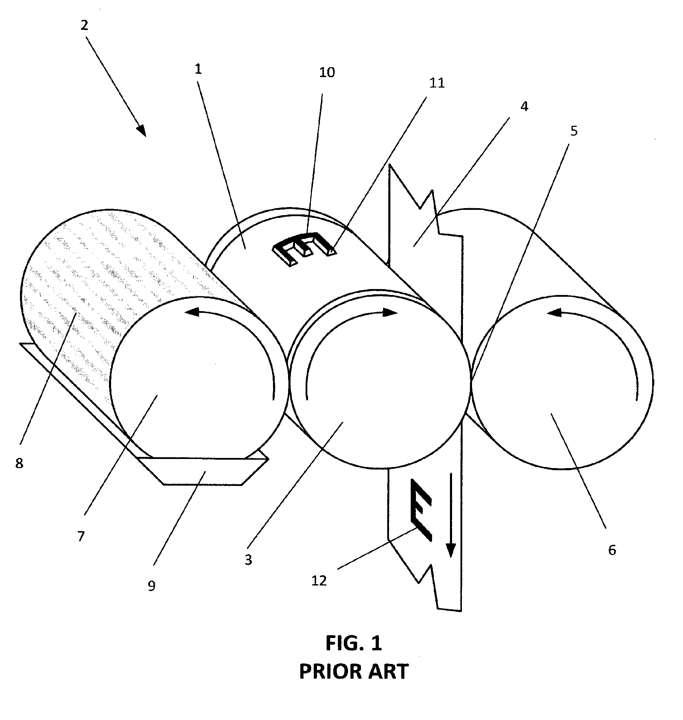

Referring now to the drawings, in which like elements in the several figures are represented by like reference characters, Figure 1 is a simplified, not-to-scale representation in perspective view of a flexographic plate 1 in use on a printing machine 2. The flexographic plate 1 (so called because it is made from flexible material, flexed into a cylindrical shape, and comprises flexible typefaces or relief faces) is fastened to cylindrical print roll 3. A sheet of printable material, e.g., paper 4, is printed by being fed through a nip 5 between the print roll 3 and a pressure roll 6. Inking roll 7 (typically an anilox roll) picks up a liquid film of ink 8 from, e.g., an ink tray 9, transferring it to the print surface 10 of a relief image 11 integral to the flexographic plate 1. The print surface 10 prints an ink image 12 on the paper.

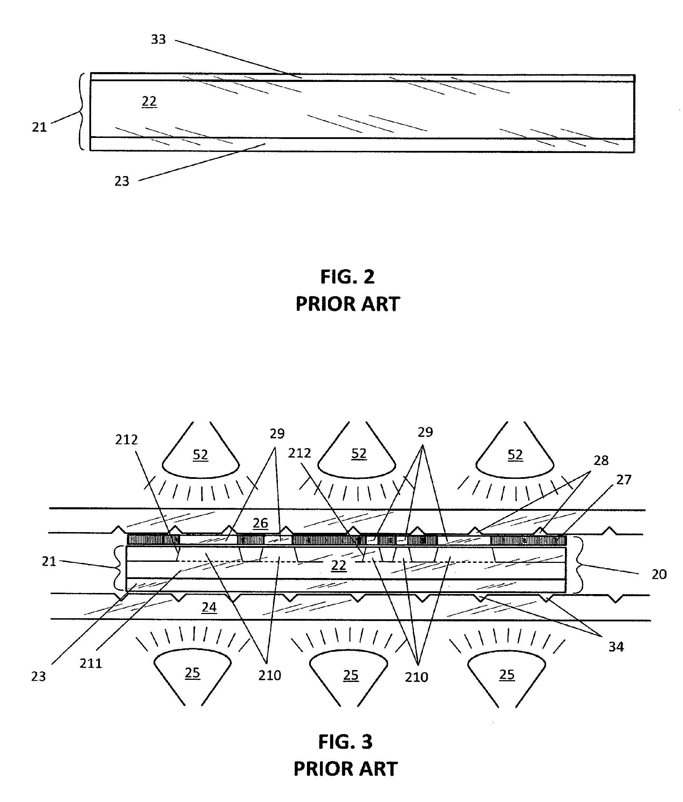

Figure 2 is a magnified, not-to-scale cross-sectional view of sheet photopolymer 21 both of the prior art and as used in the present invention. The sheet photopolymer is made up of a flexible layer of uncured photopolymer 22 affixed to a thin, flexible backing sheet 23 of photo-transmissive polyester, PVC, or other plastic. The print surface of the sheet photopolymer is protected by a slip film 33, typically polyester. The slip film 33 may be removed depending on how the sheet photopolymer 21 is to be used. Preferably, the slip film 33 of the present invention is to be left in place so that the relief negative image is printed on it and not removed until after the sheet photopolymer is exposed and removed from the exposure unit. Within the scope of this invention, however, the slip film 33 could be removed before printing and the relief image printed directly on it.

Figure 3 is a cross-sectional illustration of a prior art method of using a sheet photopolymer 21 in an arrangement of other layers 20 to make a flexographic plate. Slip film 33 has been removed from sheet photopolymer 21 before placing it in the plate-making system (exposure unit) and is therefore not visible in this view. In this and the following figures, only the parts of the exposure unit that relate to the present invention are shown. The principal parts of the plate-making system used to make a flexographic plate from the sheet photopolymer are a flat, horizontal bottom glass 24, lower UV lights 25 mounted below the bottom glass in the base of the exposure unit, and, mounted in a lid (not shown), a flat top glass 26 and upper UV lights 52. The lid (not shown) is hinged to the base of the exposure unit so that the top glass may be lowered into a horizontal position, as shown, on top of the plate-making arrangement 20 after the plate-making arrangement 20 is placed on the bottom glass 24.

After a photographic negative of the relief areas to be printed is made either by a film, digital, or inkjet method described above, the steps involved in making a traditional flexographic plate from a sheet photopolymer are:
a. Place a sheet of unexposed sheet photopolymer 21 on the bottom glass 24 with the backing sheet 23 against the bottom glass 24;
b. Place the image negative 27 (the black areas of the negative are represented here by vertical hatching, even though the thickness of the image material is minuscule) on top of the sheet photopolymer 21;
c. cover the entire plate-making arrangement 20 with a vacuum sheet (not shown);
d. Lower the top glass 26 over the plate-making arrangement 20;
e. Turn on a vacuum source (not shown) connected to the lower vacuum grooves 34 to remove air from between the various layers;
f. Turn on the lower UV lights 25 for a prescribed amount of time to shine through the lower glass 26, causing a uniform floor layer 211 to form in the photopolymer layer 22 above the backing sheet 23;
g. Turn on the upper UV lights 52 to shine through the clear areas 29 in the negative 27, causing vertical regions 210 the sheet photopolymer below the clear areas 29 to polymerize and bond to the floor layer 211 (at the horizontal dashed lines); and
h. remove the exposed sheet photopolymer from the unit for further processing to create the relief image, namely, by mechanically removing the un-polymerized photopolymer from above the floor layer 211 by scrubbing the sheet photopolymer with solvent.

Note in this and the following figures that the lateral boundaries 212 between the exposed, polymerized photopolymer and the unexposed, un-polymerized photopolymer are inclined from the vertical by about 30 degrees, making the bases of the vertical regions 210 wider farther away from the light source than they are close to the light source. These "shoulders" form on the sides of the vertical regions 210 because the light spreads out as it passes through the photopolymer. This effect can be controlled by the shape of the light source and the thickness of the photopolymer layer, and, properly controlled, is beneficial in that it increases the dimensional stability of the vertical regions during the printing process.

As in any process where an image is formed by blocking light by interposing a mask directly over a photosensitive surface, the closer the mask is to the surface, the sharper the image formed. Application of vacuum to the grooves 28 removes air from among the imaging-related layers in the plate-making arrangement 20, thus pulling the image mask closer to the photopolymer layer. The closeness of the mask (in this case the single negative 27) to the sheet photopolymer layer 22 depends on how well the vacuum applied at the grooves 28 reaches the boundary between those two layers. The vacuum is maximally effective here because this boundary is the only one to be evacuated other than the ones that necessarily exist at the glass surfaces.

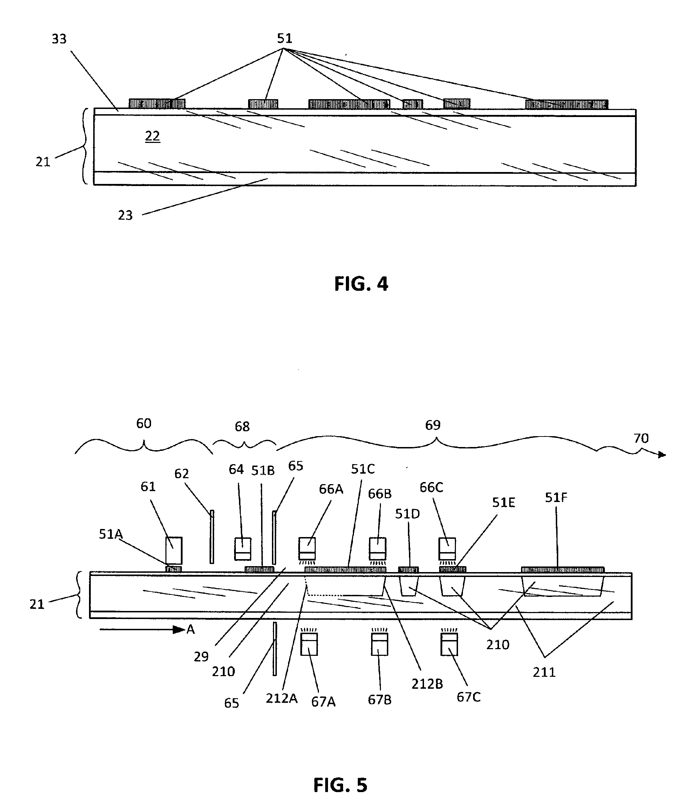

Figure 4 is a magnified, not-to-scale cross-sectional view of the first embodiment of the present invention, namely a solvent ink negative image 51 printed on the slip film 33 of a sheet photopolymer 21. The solvent ink is made in accordance with U.S. Patent Application No. 13/902,301, and is thus satisfactorily printed to the required opacity on the typical slip film material, polyester, e.g., polyethylene terephthalate (PET) using one print-head pass of an inkjet printer. While inkjet printing is the current technology of choice for precise additive imaging, the present invention applies to any method of ink application which allows the masking image to be applied in a single laydown. Eliminating the need for plural laydowns speeds the process of image creation but also removes any issues with registration of duplicate laydowns.

Moreover, using this embodiment, the entire relief image negative (see element 27 in Fig. 3) of the prior art is eliminated, along with the air-containing interface between the negative and the slip film of the prior art (see element 33 in Fig. 2). The scope of this invention includes other solvent ink-receptive films or layers applied to the upper surface of sheet photopolymers such as, by example and not limited to, mixtures or copolymers containing both polyvinyls and polyethylenes.

Preferably, and depending on the particular chemical makeup of the inks, the printed sheets may be heated to up about 50°C to dry the ink more quickly. This improves image sharpness by reducing migration of wet ink after laydown, and formation of vapor bubbles in the ink.

Steps for preparing a flexo plate from sheet photopolymer starting with the laminate of the first embodiment as shown in Fig. 4 in which the backing sheet 23 and slip film 33 are made of polyester, are as follows:
a. Print the digital representation of the negative of the relief image 51 on the slip film 33 of a sheet photopolymer 21 (see Fig. 4) using a single pass of the print head suitable inkjet printer;
b. Optionally heat the printed sheet photopolymer to a temperature of up to about 50°C;
c. Place the printed sheet photopolymer 21 backing side down on the bottom glass of a UV exposure unit;
d. Shine polymerizing light through the printed laminate for an amount of time suitable to form a uniform floor of a desired thickness in the photopolymer sheet;
e. Shine polymerizing light through the relief negative image 51 for an amount of time suitable to form a polymerized relief image in the sheet photopolymer between the polymerized floor and the slip film 33; and
f. Post-process the exposed sheet photopolymer in accordance with normal practice to remove the ink, slip film and unpolymerized photopolymer, and fix the polymerized floor and relief images.

Figure 5 is a magnified, not-to-scale cross-sectional view of the second embodiment of the present invention, namely a schematic of a combined inkjet printing and relief image creating machine in the process of sequentially printing the laminate of Fig. 4 and producing a polymerized relief-imaged plate ready for post-processing. A fresh, unprinted sheet photopolymer 21, having been introduced into the inkjet printer portion 60 of this embodiment, is having relief negative image 51 A printed on it by an inkjet printer head 61. The sheet polymer 21 is moving in the direction A while the printer head 61 moves back and forth in a direction toward and away from the viewer. Thus the image 51A represents a single pass of the head 61 toward the viewer (a single laydown of ink). When head 61 reaches its farthest point toward the viewer, sheet 21 will index in direction A and head 61 will move away from the viewer, laying down ink as programmed. A stationary opaque baffle 62 prevents light from entering the printer portion 60. Section 68 is an optional sheet treating section, which, in this embodiment and depending on the composition of the ink and the process speed, is an optional heat source 64 (for example, but without limitation, an infrared-emitting LED). This heats the ink image 51B under it to a surface temperature of up to about 50°C to dry it before the ink has time to migrate. In this embodiment, sheet 21 is still indexing in direction A as print head 61 makes each pass, and moves sheet 21 from optional treating section 68 to curing section 69. A second baffle 65 may be positioned above and below the sheet 21 to prevent UV radiation from lamps 66 and 67 from partially curing photopolymer under image 51B. Clear sheet upper surface area 29, having already moved past baffle 65, is having photopolymer 210 under it cured both by upper UV source 66A and lower UV source 67A. A nascent interface 212A (dotted line) between polymerized 211 and unpolymerized 211 material is forming to a depth determined by the programmed time and intensity of the exposure from both of these UV sources. The arrays of ultraviolet LEDs 66A-C and 67A-C can be controlled much more precisely in this regard than fluorescent tubes currently in use.

Continued UV exposure can be programmed into the process to produce sufficiently distinct interfaces 212B between cured photopolymer 211 and uncured photopolymer 210 as the sheet 21 moves farther in direction A.

Fig. 5 also shows that a plate finishing section 70 can be appended to curing section 69, which can include e.g., solvent washing and mechanical scrubbing.

## Claims

1. A method for making a flexographic printing plate (1), **characterised in** the steps of:
(a) adding a sufficient amount of UV absorbers to a solvent-based ink to create an ink composition having an opacity in the UV spectrum of at least about 3;
(b) providing a sheet photopolymer (21) having a backing sheet (23), the backing sheet (23) having a bottom surface, a photopolymer layer (22) on top of the backing sheet (23), the photopolymer layer (22) having a top surface;
(c) applying a single layer of the ink composition onto a portion of the top surface to provide a photomask image (51);
(d) optionally exposing the bottom surface to UV radiation sufficient to cure a floor thickness of the photopolymer layer (22) of at least zero thickness adjacent to the backing sheet (23);
(e) exposing the top surface to UV radiation sufficient to cure the unmasked photopolymer layer (22) to a depth of cured photopolymer that is contiguous with the floor thickness; and
(f) processing the exposed sheet photopolymer (21) under conditions effective to render the cured unmasked portion (210) of the photopolymer layer (22) into a raised image surface suitable for use in a flexographic printing process.

2. A method as claimed in claim 1, **characterised in that** said top surface comprises a slip film (33), and the photomask layer (51) is applied to the slip film (33).

3. A method as claimed in claim 1 or claim 2, **characterised in that** after step (c), said top surface to which said ink composition is applied is heated.

4. A method as claimed in any of claims 1 to 3, **characterised in that** after step (c), said top surface to which said ink composition is applied is heated.

5. A laminate, comprising:
a sheet photopolymer (21) having a top surface;
a solvent-based ink composition applied to a portion of the top surface to produce a photomask image (51) in which every portion of the photomask image (51) is created in single non-overlapping passes of an inkjet print head;
the solvent-based ink composition comprising at least one UV radiation-absorbing substance and at least one other UV radiation-filtering substance taken from the list of:
a. at least one fluorescent substance;
b. at least one UV radiation-reflecting substance; and
c. any combination of the above;
the composition when dry on the top surface having a UV opacity of at least about 3.

6. A machine for making a flexo plate **characterised in** an inkjet printer (60);
the printer (60) comprising programmable means for inputting, printing, and outputting a sheet photopolymer (21) with a printed surface; an ink treating section (68) contiguous with the printer output comprising programmable means for taking in the printed sheet photopolymer (21) line-by-line as it is printed, treating it, and outputting the treated sheet photopolymer (68); and
an exposure section (69) contiguous with the treating section output comprising programmable means for taking in the printed and treated sheet photopolymer and exposing it to actinic radiation (67A-68C).

7. A machine as claimed in claim 6, **characterised in that** said ink treating section (68) heats the printed surface and said exposure section (69) comprises ultraviolet-emitting LEDs (67A-68C).

8. A machine as claimed claim 6 or claim 7, **characterised in that** there is a plate finishing section (70) contiguous with said exposure section (69).
